# EUROPEAN PATENT APPLICATION

(11) **EP 4 421 148 A1**
(43) Date of publication of application: **28.08.2024**
(21) Application number: 24159039.7
(22) Date of filing: 22.02.2024
(51) Int. Cl.: C09K 13/06, C23F 1/26

(54) **ETCHING COMPOSITION FOR TITANIUM-CONTAINING LAYER, ETCHING METHOD OF ETCHING TITANIUM-CONTAINING LAYER, AND METHOD OF MANUFACTURING SEMICONDUCTOR DEVICE USING THE ETCHING COMPOSITION**

(30) Priority: 24.02.2023 KR 20230025290
(71) Applicant: Samsung Electronics Co., Ltd., Suwon-si, Gyeonggi-do 16677 (KR)
(72) Inventor: KANG, Byungjoon, 16678 Suwon-si (KR); KIM, Sungmin, 16678 Suwon-si (KR); SUNG, Minjae, 18448 Hwaseong-si (KR); SONG, Gayoung, 18448 Hwaseong-si (KR); OH, Jungmin, 18448 Hwaseong-si (KR); LEE, Hyosan, 18448 Hwaseong-si (KR); CHOI, Byoungki, 16678 Suwon-si (KR); HAM, Cheol, 16678 Suwon-si (KR); HWANG, Kyuyoung, 16678 Suwon-si (KR)
(74) Representative: Elkington and Fife LLP

(57) **Abstract**

Provided are an etching composition for a titanium-containing layer, a method of etching a titanium-containing layer by using the etching composition, and a method of manufacturing a semiconductor device by using the etching composition, the etching composition including an oxidant, an inorganic acid, and a selective etching inhibitor, wherein the inorganic acid includes phosphorus-based inorganic acid, chlorine-based inorganic acid, fluorine-based inorganic acid, or any combination thereof, and the selective etching inhibitor includes a polymer having a nitrogen-containing repeating unit.

## Description

### FIELD OF THE INVENTION

The disclosure relates to an etching composition for a titanium-containing layer, a method of etching a titanium-containing layer by using the etching composition, and a method of manufacturing a semiconductor device by using the etching composition.

### BACKGROUND OF THE INVENTION

To satisfy excellent performance and low price demanded by consumers, an increase in the degree of integration and an improvement in the reliability of semiconductor devices are required. As the degree of integration of semiconductor devices increases, damage to components of semiconductor devices during a process of manufacturing semiconductor devices has a greater effect on reliability and electrical characteristics of semiconductor memory devices. In particular, in the process of manufacturing semiconductor devices, various etching processes may be performed on a predetermined layer (e.g., a titanium-containing layer). However, to perform an effective etching process, the need for an etching composition capable of providing an excellent etching speed, excellent etching selectivity for adjacent layers, the absence of surface residue after etching, excellent storage stability, and the like has been continuously demanded.

### SUMMARY OF THE INVENTION

Provided is an etching composition having an excellent etching speed for a titanium-containing layer, which is a target layer to be etched, and excellent etching selectivity for adjacent layers, and at the same time, having excellent storage stability without substantially leaving no surface residue on a surface of a target etching layer after etching.

Additional aspects will be set forth in part in the description which follows and, in part, will be apparent from the description, or may be learned by practice of the presented embodiments of the disclosure.

According to an aspect of the disclosure, an etching composition includes
an oxidant, an inorganic acid, and a selective etching inhibitor,
wherein the inorganic acid includes phosphorus-based inorganic acid, chlorine-based inorganic acid, fluorine-based inorganic acid, or any combination thereof, and
the selective etching inhibitor includes a polymer having a nitrogen-containing repeating unit.

The oxidant may be hydrogen peroxide.

The inorganic acid may include phosphoric acid.

The nitrogen-containing repeating unit may include at least one of a repeating unit represented by Formula 1-1, a repeating unit represented by Formula 1-2, a repeating unit represented by Formula 1-3, and a repeating unit represented by Formula 1-4: 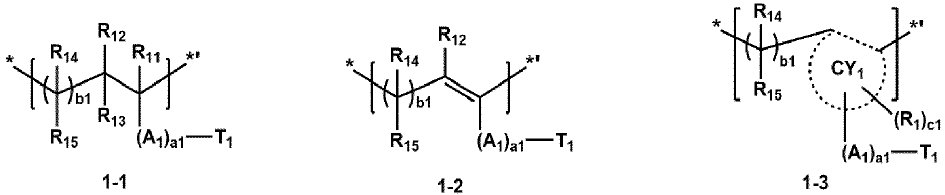 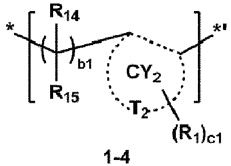
wherein A₁ in Formulae 1-1 to 1-3 may be *-C(R₁₆)(R₁₇)-*', *-N(R₁₆)-*', *-C(=O)-*', *-O-*', or *-S-*',
a1 in Formulae 1-1 to 1-3 may be an integer from 0 to 20, and when a1 is 2 or more, two or more of A₁ may be identical to or different from each other,
b1 in Formulae 1-1 to 1-4 may be an integer from 0 to 10, and when b1 is 2 or more, at least two of *-C(R₁₄)(R₁₅)-*' may be identical to or different from each other,
T₁ in Formulae 1-1 to 1-3 may be *-N(Z₁₁)(Z₁₂), *-[N(Z₁₁)(Z₁₂)(Z₁₃)⁺[Z₁₄]⁻, a group represented by Formula AN, or a g represented by Formula BN: 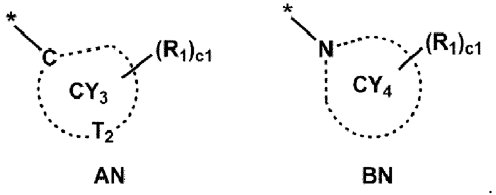
ring CY₁ to ring CY₄ in Formulae 1-3, 1-4, AN, and BN may each independently be a C₂-C₁₀ cyclic group,
c1 in Formulae 1-3, 1-4, AN, and BN may be an integer from 0 to 10, and when c1 is 2 or more, two or more of R₁ may be identical to or different from each other,
T₂ in Formulae 1-4 and AN may be *-N(Z₁₁)-*' or *-[N(Z₁₁)(Z₁₂)]⁺[Z_{14]}⁻-*',
R₁, R₁₁ to R₁₇, and Z₁₁ to Z₁₃ may each independently be
hydrogen, deuterium, *-F, *-Cl, *-Br, *-I, *-OH, *-SH, *-C(=O)-Q₁, *-NH-C(=O)-Q₁, *-C(=O)-O-O₁, *-SO₂-Q₁, *-P(=O)-(Q₁)(Q₂), *-N(Q₁)(Q₂), *-[N(Q₁)(Q₂)(Q₃)]⁺[Q_{4]}⁻, or *-(O-CH₂CH₂)ₙ₁-OH, or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-Q₁₁, *-NH-C(=O)-Q₁₁, *-C(=O)-O-Q₁₁, *-SO₂-Q₁₁, *-P(=O)-(Q₁₁)(Q₁₂), *-N(Q₁₁)(Q₁₂), *-[N(Q₁₁)(Q₁₂)(Q₁₃)]⁺[Q₁₄]⁻, *-(O-CH₂CH₂)ₙ₂-OH, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof,
n1 and n2 may each independently be an integer from 1 to 20,
two or more of R₁, R₁₁, R₁₂, R₁₃, R₁₄, R₁₅, R₁₆, R₁₇, Z₁₁, Z₁₂, and Z₁₃ may optionally be linked together to form a C₂-C₁₀ cyclic group,
Q₁ to Q₃ and Q₁₁ to Q₁₃ may each independently be
hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂, or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof,
[Z₁₄]⁻, [Q₄]⁻, and [Q₁₄]⁻ may each be an anion, and
* and *' each indicate a binding site to a neighboring atom.

The polymer having the nitrogen-containing repeating unit may be a homopolymer.

In Formula 1-3, CY₁ may be a cyclopropane group, a cyclobutane group, a cyclopentane group, a cyclohexane group, a cycloheptane group, a cyclooctane group, an oxirane group, an oxetane group, a tetrahydrofuran group, or a tetrahydropyran group.

In Formula 1-4, ring CY₂ may be a saturated cyclic group having 4, 5, 6, or 7 carbon atoms.

In Formula AN,
i) T₂ may be *-N(Z₁₁)-*', and ring CY₃ may be a pyrrole group, an imidazole group, a pyrazole group, an aziridine group, an azetidine group, a pyrrolidine group, or a piperidine group, or
ii) T₂ may be *-[N(Z₁₁)(Z₁₂)⁺[Z₁₄]⁻-*', and ring CY₃ may be a saturated cyclic group having 4, 5, 6, or 7 carbon atoms.

In Formula BN, ring CY₄ may be a pyrrole group, an imidazole group, a pyrazole group, an aziridine group, an azetidine group, a pyrrolidine group, or a piperidine group.

The selective etching inhibitor may include: a first polymer having a first nitrogen-containing repeating unit; and a second polymer having a second nitrogen-containing repeating unit, wherein the first nitrogen-containing repeating unit and the second nitrogen-containing repeating unit may each independently include at least one of the repeating unit represented by Formula 1-1, the repeating unit represented by Formula 1-2, the repeating unit represented by Formula 1-3, and the repeating unit represented by Formula 1-4, and the first nitrogen-containing repeating unit and the second nitrogen-containing repeating unit may be different from each other.

The selective etching inhibitor may further include an amine-containing compound, and the amine-containing compound may be different from the polymer having the nitrogen-containing repeating unit.

The amine-containing compound may include alkylamine, alkanolamine, or any combination thereof.

An amount of the selective etching inhibitor may be in a range of about 0.001 wt% to about 20 wt% per 100 wt% of the etching composition.

An amount of the oxidant may be in a range of about 0.5 wt% to about 20 wt% per 100 wt% of the etching composition, an amount of the inorganic acid may be in a range of about 30 wt% to about 80 wt% per 100 wt% of the etching composition, and an amount of the selective etching inhibitor may be in a range of about 0.01 wt% to about 0.5 wt% per 100 wt% of the etching composition.

According to another aspect of the disclosure, a method of etching a titanium-containing layer includes
preparing a substrate provided with a titanium-containing layer, and
removing at least a portion of the titanium-containing layer by performing an etching process on the titanium-containing layer using the etching composition.

The titanium-containing layer may further comprise indium (In), aluminum (Al), tungsten (W), cobalt (Co), lanthanum (La), scandium (Sc), gallium (Ga), molybdenum (Mo), ruthenium (Ru), zinc (Zn), hafnium (Hf), or any combination thereof.

The titanium-containing layer may have a first region and a second region, a second etching rate of the etching composition for etching the second region may be greater than a first etching rate of the etching composition for etching the first region, and the etching process may be performed by contacting at least a portion of the first region and at least a portion of the second region with the etching composition.

The first region or the second region may include a titanium nitride.

According to another aspect of the disclosure, a method of manufacturing a semiconductor device includes
preparing a substrate provided with a titanium-containing layer,
removing at least a portion of the titanium-containing layer by performing an etching process on the titanium-containing layer using the etching composition, and
performing a subsequent manufacturing process on a structure having the substrate including the titanium-containing layer.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a process flow chart of an embodiment of a method of manufacturing a semiconductor device; and
FIGS. 2 and 3 are each a diagram briefly explaining an embodiment of a method of etching a titanium-containing layer.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figure, to explain aspects. As used herein, the term "and/or" includes any and all combinations of one or more of the associated listed items. Expressions such as "at least one of," when preceding a list of elements, modify the entire list of elements and do not modify the individual elements of the list.

### Titanium-containing layer

A target layer to be etched is a titanium-containing layer.

The titanium-containing layer includes titanium. In this regard, an etching composition described below may be used in an etching process and/or a chemical mechanical polishing (CMP) process for the titanium-containing layer.

The titanium-containing layer may further include, in addition to titanium, an alkali metal (e.g., sodium (Na), potassium (K), rubidium (Rb), cesium (Cs), etc.), an alkaline earth metal (e.g., beryllium (Be), magnesium (Mg), calcium (Ca), strontium (Sr), barium (Ba), etc.), a lanthanide metal (e.g., lanthanum (La), europium (Eu), terbium (Tb), ytterbium (Yb), etc.), a transition metal (e.g., scandium (Sc), yttrium (Y), zirconium (Zr), hafnium (Hf), vanadium (V), niobium (Nb), tantalum (Ta), chromium (Cr), molybdenum (Mo), tungsten (W), manganese (Mn), iron (Fe), ruthenium (Ru), osmium (Os), cobalt (Co), rhodium (Rh), nickel (Ni), silver (Ag), zinc (Zn), etc.), a post-transition metal (e.g., aluminum (Al), gallium (Ga), indium (In), thallium (Tl), tin (Sn), bismuth (Bi), etc.), or any combination thereof.

In an embodiment, the titanium-containing layer may further include indium (In), aluminum (Al), tungsten (W), cobalt (Co), lanthanum (La), scandium (Sc), gallium (Ga), molybdenum (Mo), ruthenium (Ru), zinc (Zn), hafnium (Hf), or any combination thereof.

For example, the titanium-containing layer may further include at least one of Al, La, W, Mo, or any combination thereof.

For example, the titanium-containing layer may further include W or Mo. The titanium-containing layer may include at least one of a titanium nitride, a titanium oxide, titanium oxynitride, or a combination thereof.

The titanium-containing layer may include a titanium nitride.

The titanium nitride may further include In, Al, La, Sc, Ga, Hf, Zn, or any combination thereof. In one or more embodiments, the titanium-containing layer may include titanium nitride (TiN), titanium nitride that further includes Al (e.g., titanium/aluminum nitride (TiAlN)), titanium nitride that further includes La, or the like.

In one or more embodiments, the titanium-containing layer may include a titanium oxide. The titanium oxide may include Al, La, Sc, Ga, Hf, or any combination thereof. In an embodiment, the titanium-containing layer may include aluminum oxide (e.g., Al₂O₃), indium gallium zinc oxide (IGZO), or the like.

In one or more embodiments, the titanium-containing layer may include the titanium nitride and the titanium oxide.

In one or more embodiments, the titanium-containing layer may further include a metalloid (e.g., boron (B), silicon (Si), germanium (Ge), arsenic (As), antimony (Sb), tellurium (Te), etc.), non-metal (e.g., nitrogen (N), phosphorus (P), oxygen (O), sulfur (S), selenium (Se), etc.), or any combination thereof.

For example, the titanium-containing layer may further include silicon oxide.

The titanium-containing layer may have a single-layer structure including (or consisting of) at least on type of materials or a multi-layer structure or pattern structure including different materials from each other. For example, the titanium-containing layer may have i) a single-layer structure including (or consisting of) titanium nitride, ii) a double-layer structure or pattern structure including a first layer including (or consisting of) titanium nitride and a second layer including (or consisting of) titanium nitride, which further includes Al, iii) a double-layer structure or pattern structure including a first layer including (or consisting of) titanium nitride and a second layer including (or consisting of) aluminum oxide, iv) a double-layer structure or pattern structure including a first layer including (or consisting of) titanium nitride and a second layer including (or consisting of) W or Mo, or the like.

In one or more embodiments, the titanium-containing layer may have a first region and a second region, and a second etching rate of the etching composition for etching the second region may be greater than a first etching rate of the etching composition for etching the first region. During the etching process and/or CMP process for the titanium-containing layer, at least a portion of the first region and at least a portion of the second region may be in contact with the etching composition, and since the second etching rate is greater than the first etching rate, the second region may be etched faster than the first region.

In one or more embodiments, a) the first region, b) the second region, or c) the first region and the second region, may include titanium (Ti).

In one or more embodiments, a) the first region, b) the second region, or c) the first region and the second region, may include a metal nitride.

In one or more embodiments, a) the first region, b) the second region, or c) the first region and the second region, may include i) titanium nitride, ii) titanium nitride further including In, Al, La, Sc, Ga, Zn, Hf, or any combination thereof, or iii) a combination thereof.

In one or more embodiments, a) the first region, b) the second region, or c) the first region and the second region, may include a titanium nitride.

In one or more embodiments, the first region or the second region may include a titanium nitride.

In one or more embodiments, the first region may include Ti, and the second region may not include Ti.

In one or more embodiments, the first region may not include Ti, and the second region may include Ti.

In one or more embodiments, a) the first region, b) the second region, or c) the first region and the second region, may include In, Al, W, Co, La, Sc, Ga, Mo, Ru, Zn, Hf, or any combination thereof.

In one or more embodiments, each of the first region and second region may include i) titanium nitride, ii) titanium nitride further including In, Al, La, Sc, Ga, Zn, Hf, or any combination thereof, or iii) a combination thereof.

In one or more embodiments, the first region may include W, and the second region may not include W.

In one or more embodiments, the first region may include W, and the second region may include titanium nitride (TiN).

In one or more embodiments, the first region may include a W film, and the second region may include a titanium nitride film (TiN film).

In one or more embodiments, the first region may be a W film, and the second region may be a titanium nitride film (TiN film).

In one or more embodiments, the first region may not include Mo, and the second region may include Mo.

In one or more embodiments, the first region may include titanium nitride (TiN), and the second region may include Mo.

In one or more embodiments, the first region may include a titanium nitride film (TiN film), and the second region may include a Mo film.

In one or more embodiments, the first region may be a titanium nitride film (TiN film), and the second region may be a Mo film.

Etching any layer described herein may refer to removing at least some of materials constituting a layer.

### Etching composition for titanium-containing layer

The etching composition may include an oxidant, an inorganic acid, and a selective etching inhibitor.

The etching composition may be used for etching the target etching layer described herein, i.e., the titanium-containing layer.

The etching composition may further include water.

In an embodiment, the etching composition may consist of an oxidant, inorganic acid, a selective etching inhibitor, and water.

In one or more embodiments, the etching composition may not include at least one of a fluorine (F)-containing compound, nitric acid, and sulfuric acid (e.g., an F-containing compound, nitric acid, and sulfuric acid).

In one or more embodiments, the etching composition may not include at least one of an F-containing compound, nitric acid, sulfuric acid and hydrochloric acid (e.g., an F-containing compound, nitric acid, sulfuric acid and hydrochloric acid).

For example, nitric acid may be improper to achieve proper etching selectivity since nitric acid can etch a material to be etched relatively slowly (for example, W etc.) in the titanium-containing layer rather quickly, sulfuric acid may be improper due to relatively lower etching selectively thereof (for example, compared to phosphoric acid) and hydrochloric acid may be improper to prepare a semiconductor device since hydrochloric acid can even damage dielectric such as silicon oxide.

The F-containing compound refers to any compound that is dissociable in an aqueous solvent while containing F, and an example thereof includes HF or the like.

### Oxidant

The oxidant may serve to etch the titanium-containing layer, and may include, for example, at least one of hydrogen peroxide and ammonium sulfate.

In an embodiment, the oxidant may include hydrogen peroxide. When hydrogen peroxide is used as the oxidant in addition to the inorganic acid, a material to be etched relatively slowly (for example, W, etc.) in the titanium-containing layer may be protected effectively during an etching process, and simultaneously, a material to be etched relatively quickly (for example, titanium nitride, etc.) in the titanium-containing layer may be removed effectively during the etching process.

An amount (weight) of the oxidant may be, for example, in a range of about 0.001 wt% to about 50 wt%, about 0.01 wt% to about 50 wt%, about 0.1 wt% to about 50 wt%, about 0.5 wt% to about 50 wt%, about 1 wt% to about 50 wt%, about 5 wt% to about 50 wt%, about 0.001 wt% to about 30 wt%, about 0.01 wt% to about 30 wt%, about 0.1 wt% to about 30 wt%, about 0.5 wt% to about 30 wt%, about 1wt% to about 30 wt%, about 5 wt% to about 30 wt%, about 0.001 wt% to about 20 wt%, about 0.01 wt% to about 20 wt%, about 0.1 wt% to about 20 wt%, about 0.5 wt% to about 20 wt%, about 1 wt% to about 20 wt%, about 5 wt% to about 20 wt%, about 10 wt% to about 25 wt%, or about 15 wt% to about 25 wt%, per 100 wt% of the etching composition.

### Inorganic acid

The inorganic acid may serve to, together with the oxidant, etch the titanium-containing layer.

The inorganic acid may include phosphorus-based inorganic acid, chlorine-based inorganic acid, fluorine-based inorganic acid, or any combination thereof.

In an embodiment, the inorganic acid may not include nitric acid.

In an embodiment, the phosphorus-based inorganic acid may be a phosphate-based inorganic acid.

For example, the inorganic acid may include at least one of a phosphate-based inorganic acid and a chlorine-based inorganic acid.

In an embodiment, the inorganic acid may include phosphoric acid.

In one or more embodiments, the inorganic acid may not include sulfuric acid and hydrochloric acid.

An amount (weight) of the inorganic acid may be, for example, in a range of about 0.01 wt% to about 90 wt%, about 0.1 wt% to about 90 wt%, about 1 wt% to about 90 wt%, about 10 wt% to about 90 wt%, about 20 wt% to about 90 wt%, about 30 wt% to about 90 wt%, about 0.01 wt% to about 80 wt%, about 0.1 wt% to about 80 wt%, about 1 wt% to about 80 wt%, about 10 wt% to about 80 wt%, about 20 wt% to about 80 wt%, or about 30 wt% to about 80 wt%, per 100 wt% of the etching composition.

### Selective etching inhibitor

The selective etching inhibitor may interact with a metal atom in the titanium-containing layer, which is a target layer to be etched, to control an etching speed and the like.

The selective etching inhibitor may include a polymer having a nitrogen-containing repeating unit. The polymer may be a water-soluble polymer.

For example, the polymer may be a homopolymer having the same nitrogen-containing repeating unit.

The nitrogen-containing repeating unit may include at least one of a repeating unit represented by Formula 1-1, a repeating unit represented by Formula 1-2, a repeating unit represented by Formula 1-3, and a repeating unit represented by Formula 1-4:

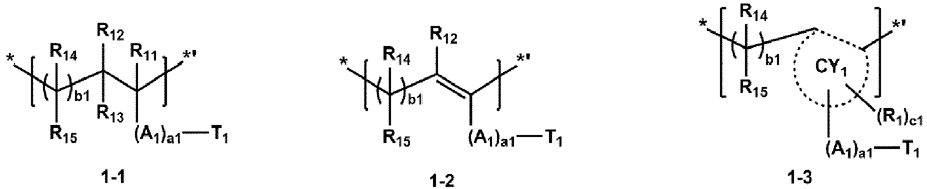

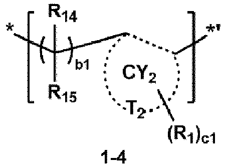

In Formulae 1-1 to 1-3, A₁ may be *-C(R₁₆)(R₁₇)-*', *-N(R₁₆)-*', *-C(=O)-*', *-O-*', or *-S-*'.

In Formulae 1-1 to 1-3, a1 may be an integer from 0 to 20, and when a1 is 2 or more, two or more of A₁ may be identical to or different from each other. When a1 is 0, *-(A₁)ₐ₁-*' may be a single bond.

In an embodiment, a1 may be 0.

In one or more embodiments, a1 may not be 0.

In one or more embodiments, a1 may be an integer from 0 to 10.

In one or more embodiments, a1 may be an integer from 1 to 5.

In Formulae 1-1 to 1-4, b1 may be an integer from 0 to 10, and when b1 is 2 or more, two or more of *-C(R₁₄)(R₁₅)-*' may be identical to or different from each other. When b1 is 0, *-C(R₁₄)(R₁₅)-*' may be a single bond.

In an embodiment, b1 may be an integer from 0 to 5.

In Formulae 1-1 to 1-3, T₁ may be *-N(Z₁₁)(Z₁₂), *-[N(Z₁₁)(Z₁₂)(Z₁₃)⁺[Z₁₄]⁻, a group represented by Formula AN, or a group represented by Formula BN:

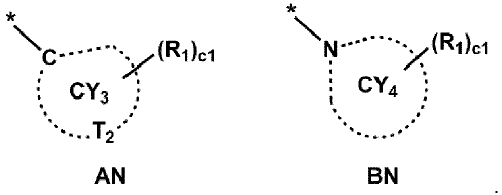

In Formulae 1-3, 1-4, AN, and BN, ring CY₁ to ring CY₄ may each independently be a C₂-C₁₀ cyclic group.

In an embodiment, T₁ in Formulae 1-1 to 1-3 may be *-N(Z₁₁)(Z₁₂) or *-[N(Z₁₁)(Z₁₂)(Z₁₃)]⁺[Z₁₄]⁻, wherein Z₁₁ to Z₁₃ may each be hydrogen.

In one or more embodiments, T₁ in Formulae 1-1 to 1-3 may be *-N(Z₁₁)(Z₁₂) or *-[N(Z₁₁)(Z₁₂)(Z₁₃)]⁺[Z₁₄]⁻, wherein Z₁₁ may be hydrogen, and Z₁₂ may not be hydrogen.

In one or more embodiments, T₁ in Formulae 1-1 to 1-3 may be *-N(Z₁₁)(Z₁₂) or *-[N(Z₁₁)(Z₁₂)(Z₁₃)⁺[Z₁₄]⁻, wherein Z₁₁ and Z₁₂ may each not be hydrogen.

In one or more embodiments, in Formulae 1-1 to 1-3, T₁ may be *-[N(Z₁₁)(Z₁₂)(Z₁₃)⁺[Z₁₄]⁻, and Z₁₁ to Z₁₃ may each not be hydrogen.

In one or more embodiments, T₁ in Formulae 1-1 to 1-3 may a group represented by Formula AN, and Z₁₁ and Z₁₂ in T₂ of Formula AN may each be hydrogen.

In one or more embodiments, T₁ in Formulae 1-1 to 1-3 may a group represented by Formula AN, and Z₁₁ in T₂ of Formula AN may not be hydrogen.

In one or more embodiments, T₁ in Formulae 1-1 to 1-3 may be a group represented by Formula AN, and T₂ in Formula AN may be *-[N(Z₁₁)(Z₁₂)]⁺[Z₁₄]⁻-*', wherein Z₁₁ and Z₁₂ may each not be hydrogen.

In one or more embodiments, Z₁₁ and Z₁₂ in T₂ of Formula 1-4 may each be hydrogen.

In one or more embodiments, in T₂ of Formula 1-4, Z₁₁ may not be hydrogen, and Z₁₂ may be hydrogen.

In one or more embodiments, T₂ in Formula 1-4 may be *-[N(Z₁₁)(Z₁₂)]⁺[Z₁₄]⁻-*', wherein Z₁₁ and Z₁₂ may not each be hydrogen.

In Formulae 1-3, 1-4, AN, and BN, c1 indicates the number of R₁, and may be an integer from 0 to 10. When c1 is 2 or more, two or more of R₁ may be identical to or different from each other.

In Formulae 1-4 and AN, T₂ may be *-N(Z₁₁)-*' or *-[N(Z₁₁)(Z₁₂)]⁺[Z₁₄]⁻-*'. Z₁₁, Z₁₂, and Z₁₄ are each the same as defined herein.

In one or more embodiments, CY₁ in Formula 1-3 may be a cyclopropane group, a cyclobutane group, a cyclopentane group, a cyclohexane group, a cycloheptane group, a cyclooctane group, an oxirane group, an oxetane group, a tetrahydrofuran group, or a tetrahydropyran group.

In one or more embodiments, ring CY₂ in Formula 1-4 may be a saturated cyclic group having 4, 5, 6, or 7 carbon atoms.

In one or more embodiments, in Formula AN,
i) T₂ may be *-N(Z₁₁)-*', and ring CY₃ may be a pyrrole group, an imidazole group, a pyrazole group, an aziridine group, an azetidine group, a pyrrolidine group, or a piperidine group, or
ii) T₂ may be *-[N(Z₁₁)(Z₁₂)⁺[Z₁₄]⁻-*', and ring CY₃ may be a saturated cyclic group having 4, 5, 6, or 7 carbon atoms.

In one or more embodiments, ring CY₄ in Formula BN may be a pyrrole group, an imidazole group, a pyrazole group, an aziridine group, an azetidine group, a pyrrolidine group, or a piperidine group.

R₁, R₁₁ to R₁₇, and Z₁₁ to Z₁₃ may each independently be:
hydrogen, deuterium, *-F, *-Cl, *-Br, *-I, *-OH, *-SH, *-C(=O)-Q₁, *-NH-C(=O)-Q₁, *-C(=O)-O-O₁, *-SO₂-Q₁, *-P(=O)-(Q₁)(Q₂), *-N(Q₁)(Q₂), *-[N(Q₁)(Q₂)(Q₃)]+[Q₄], or *-(O-CH₂CH₂)ₙ₁-OH; or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-Q₁₁, *-NH-C(=O)-Q₁₁, *-C(=O)-O-Q₁₁, *-SO₂-Q₁₁, *-P(=O)-(Q₁₁)(Q₁₂), *-N(Q₁₁)(Q₁₂), *-[N(Q₁₁)(Q₁₂)(Q₁₃)]⁺[Q₁₄], *-(O-CH₂CH₂)ₙ₂-OH, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof.
n1 and n2 may each independently be an integer from 1 to 20.
two or more of R₁, R₁₁, R₁₂, R₁₃, R₁₄, R₁₅, R₁₆, R₁₇, Z₁₁, Z₁₂, and Z₁₃ may optionally be linked together to form a C₂-C₁₀ cyclic group, and
Q₁ to Q₃ and Q₁₁ to Q₁₃ may each independently be:
   hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂; or
   a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof.

The C₃-C₃₀ carbocyclic group may be, for example, a cyclopropyl group, a cyclobutyl group, a cyclopentyl group, a cyclohexyl group, a cycloheptyl group, a cyclooctyl group, a phenyl group, a naphthyl group, or the like.

The C₁-C₃₀ heterocyclic group may be, for example, an oxiranyl group, an oxetanyl group, a tetrahydrofuranyl group, a tetrahydropyranyl group, a pyridinyl group, a pyrimidinyl group, or the like.

[Z₁₄]⁻, [Q₄]⁻, and [Q₁₄]⁻ may each be an anion.

For example, [Z₁₄]⁻, [Q₄]⁻, and [Q₁₄]⁻ may each independently be hydroxide ([OH]-), borate ([B(OH)₄]⁻), fluoride ([F]⁻), chloride ([Cl]-), bromide ([Br]⁻), iodide ([I]⁻), hydrogen sulfate ([HSO₄]⁻), nitrate ([NO₃]⁻), formate ([HCOO]⁻), acetate ([CH₃COO]⁻), or dihydrogen phosphate ([H₂PO₄]⁻).

In the present specification, * and *' each indicate a binding site to a neighboring atom unless otherwise defined.

In an embodiment, the repeating unit represented by Formula 1-3 may be represented by one of Formulae 1-3(1) to 1-3(8):

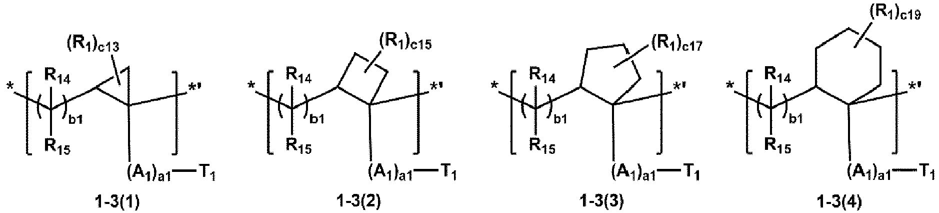

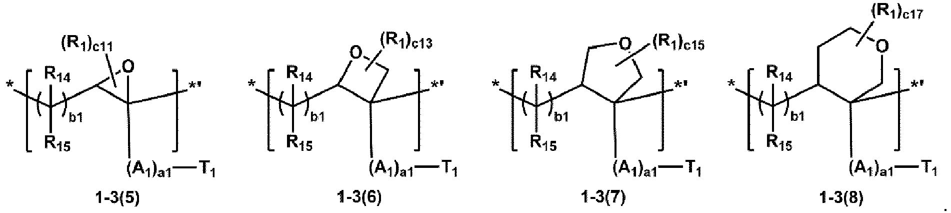

In Formulae 1-3(1) to 1-3(8),
A₁, a1, b1, T₁, R₁, R₁₄, and R₁₅ are each the same as defined herein,
c11 may be 0 or 1,
c13 may be an integer from 0 to 3,
c15 may be an integer from 0 to 5,
c17 may be an integer from 0 to 7,
c19 may be an integer from 0 to 9, and
* and *' each indicate a binding site to a neighboring atom.

In one or more embodiments, the repeating unit represented by Formula 1-4 may be represented by one of Formulae 1-4(1) to 1-4(3):

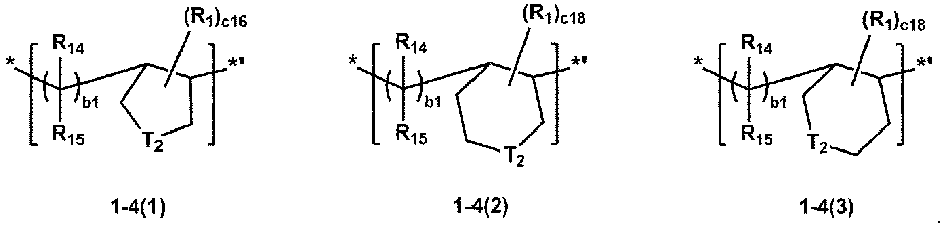

In Formulae 1-4(1) to 1-4(3),
b1, R₁, R₁₄, R₁₅, and T₂ are each the same as defined herein,
c16 may be an integer from 0 to 6,
c18 may be an integer from 0 to 8, and
* and *' each indicate a binding site to a neighboring atom.

In one or more embodiments, the group represented by Formula AN may be represented by one of Formulae AN(1) to AN(12):

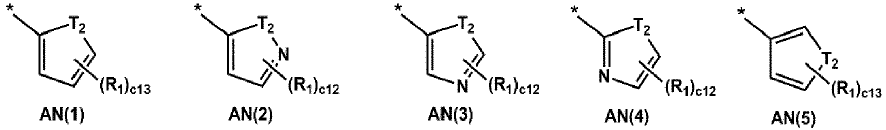

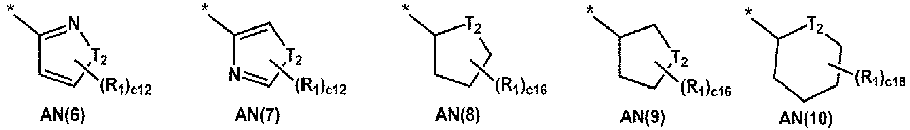

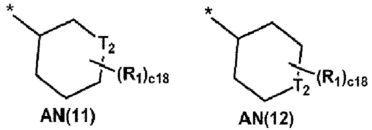

In Formulae AN(1) to AN(12),
R₁ and T₂ are each the same as defined herein,
c12 may be an integer from 0 to 2,
c13 may be an integer from 0 to 3,
c16 may be an integer from 0 to 6,
c18 may be an integer from 0 to 8, and
* indicates a binding site to a neighboring atom.

In one or more embodiments, the group represented by Formula BN may be represented by one of Formulae BN(1) to BN(7):

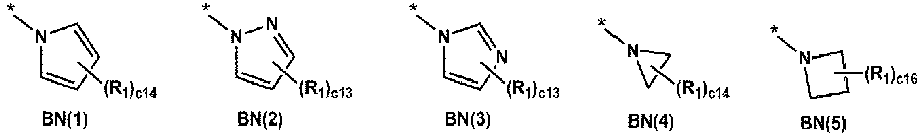

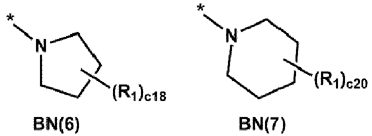

In Formulae BN(1) to BN(7),
R₁ is the same as defined herein,
c13 may be an integer from 0 to 3,
c14 may be an integer from 0 to 4,
c16 may be an integer from 0 to 6,
c18 may be an integer from 0 to 8,
c20 may be an integer from 0 to 10, and
* indicates a binding site to a neighboring atom.

A weight average molecular weight of the polymer having the nitrogen-containing repeating unit may be in a range of about 200 g/mol to about 100,000 g/mol. The weight average molecular weight may be measured by gel permeation chromatography (GPC), calculated using polystyrene.

In an embodiment, the selective etching inhibitor may include, as the polymer having the nitrogen-containing repeating unit, one type of polymer.

In one or more embodiments, the selective etching inhibitor may include, as the polymer having the nitrogen-containing repeating unit, two or more types of polymers that are different from each other. For example, the selective etching inhibitor may include: a first polymer having a first nitrogen-containing repeating unit; and a second polymer having a second nitrogen-containing repeating unit, wherein the first nitrogen-containing repeating unit and the second nitrogen-containing repeating unit may each independently include at least one of the repeating unit represented by Formula 1-1, the repeating unit represented by Formula 1-2, the repeating unit represented by Formula 1-3, and the repeating unit represented by Formula 1-4, and the first nitrogen-containing repeating unit and the second nitrogen-containing repeating unit may be different from each other.

In one or more embodiments, the polymer having the nitrogen-containing repeating unit may be one of Polymers 1 to 307:

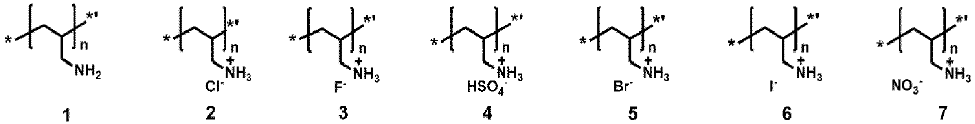

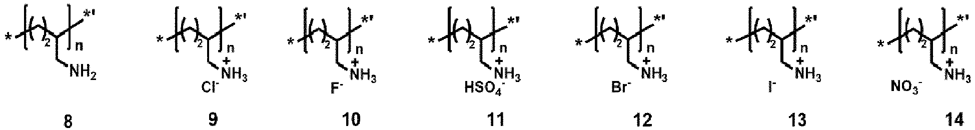

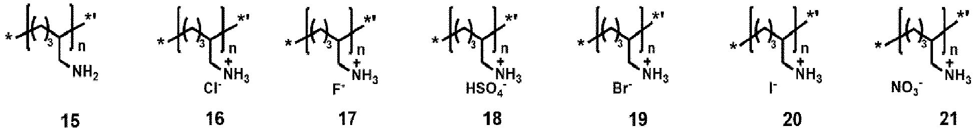

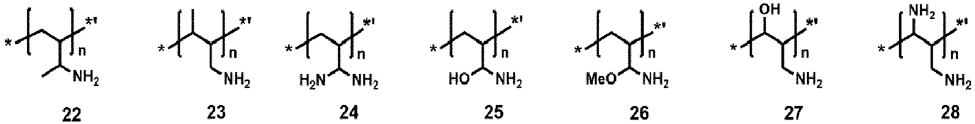

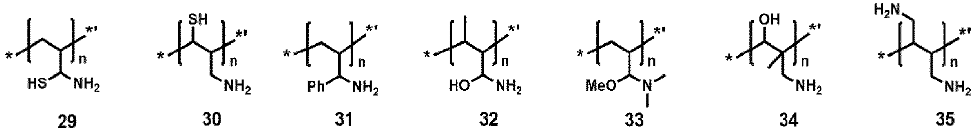

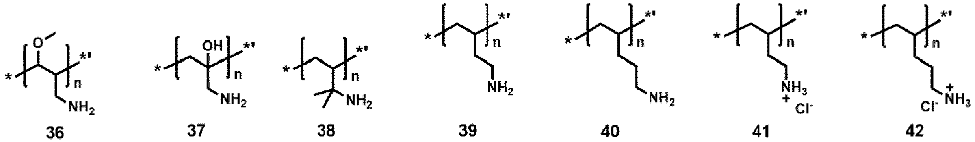

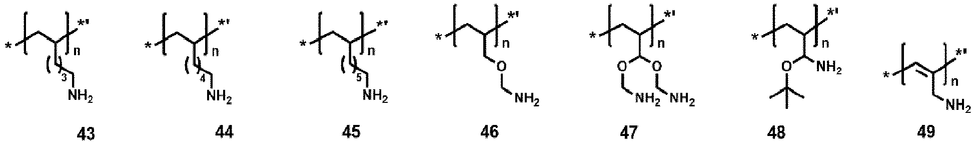

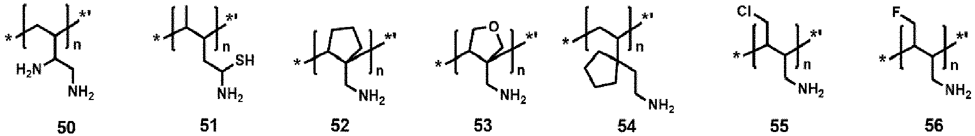

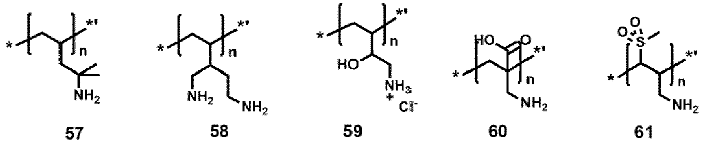

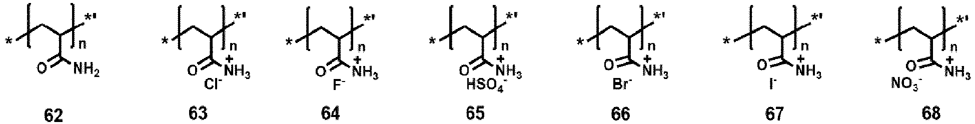

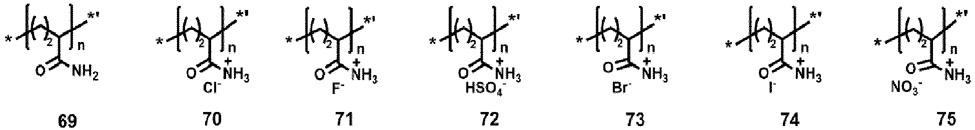

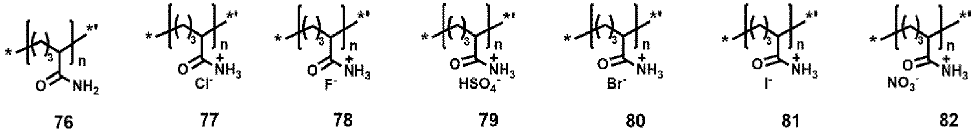

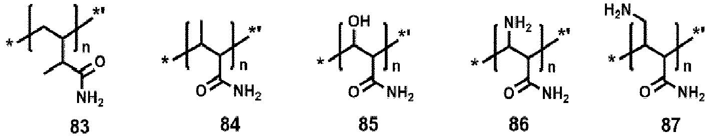

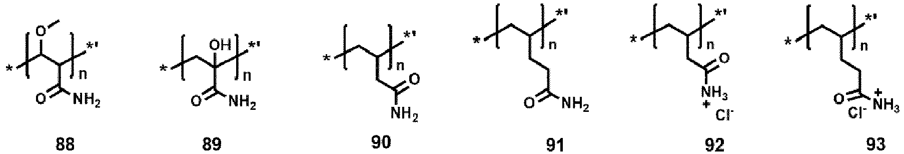

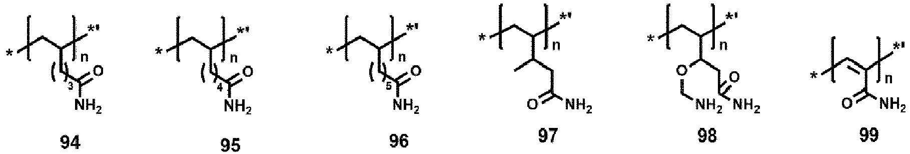

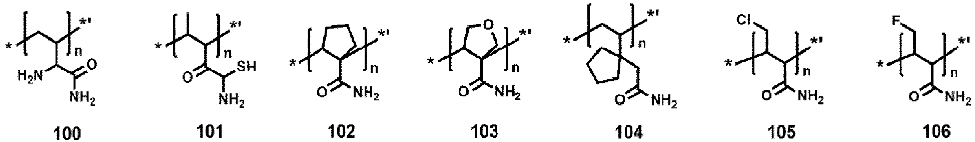

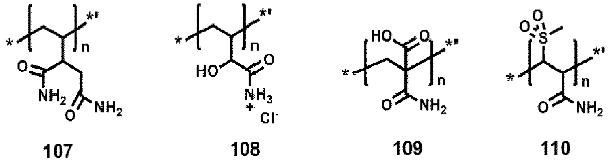

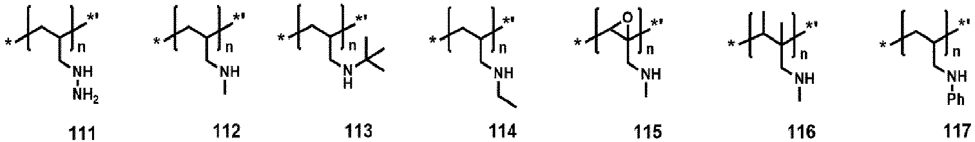

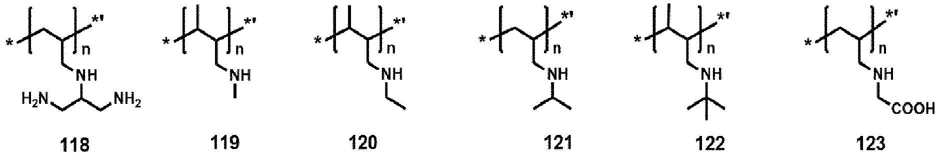

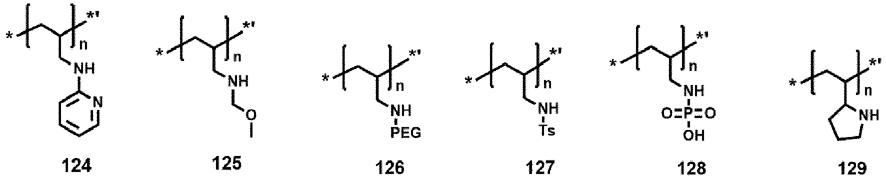

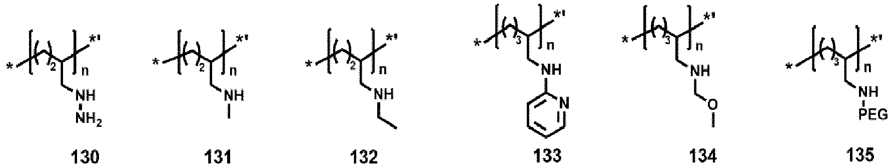

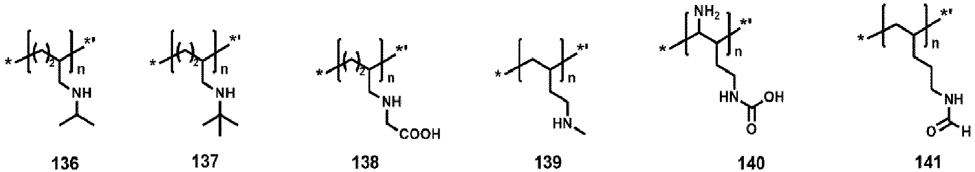

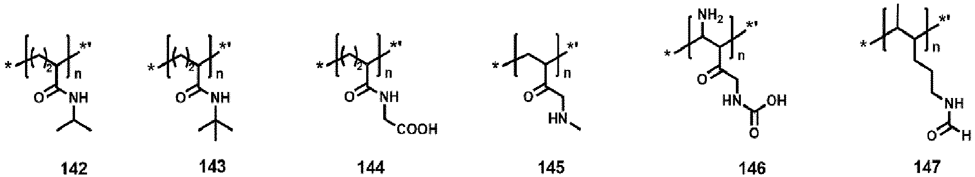

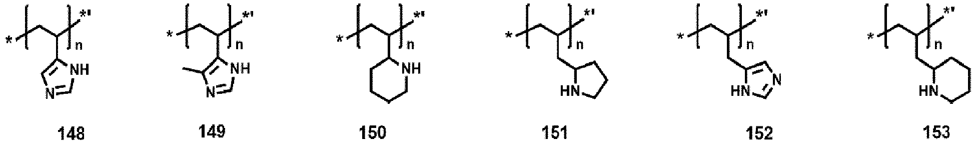

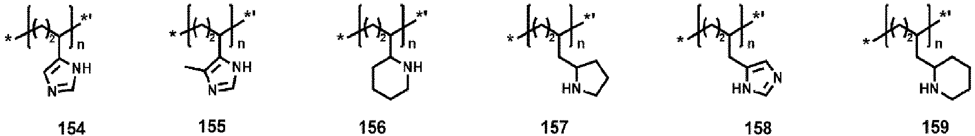

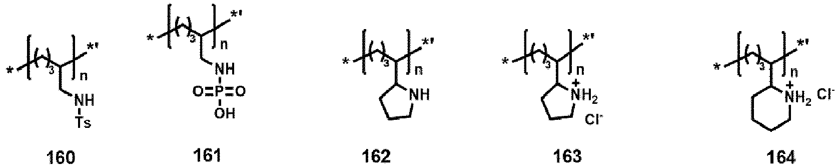

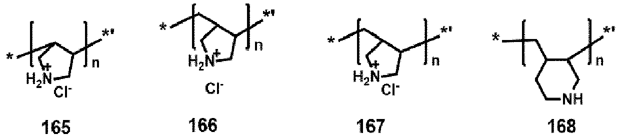

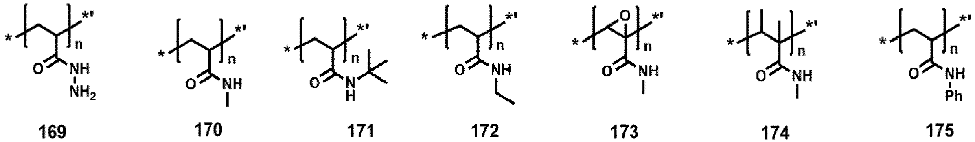

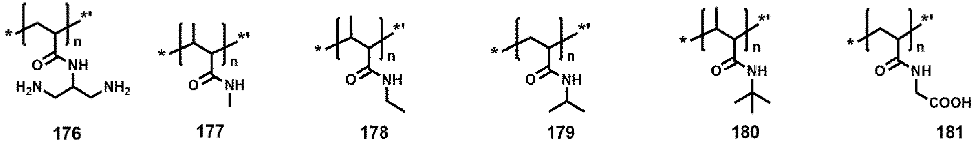

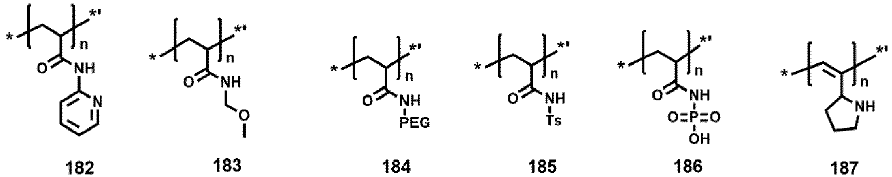

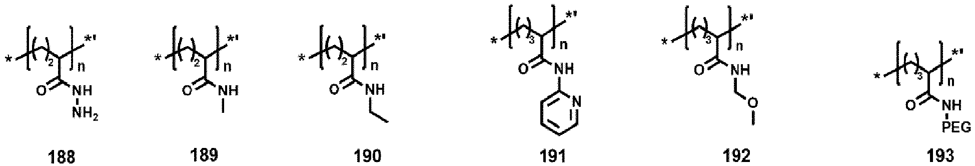

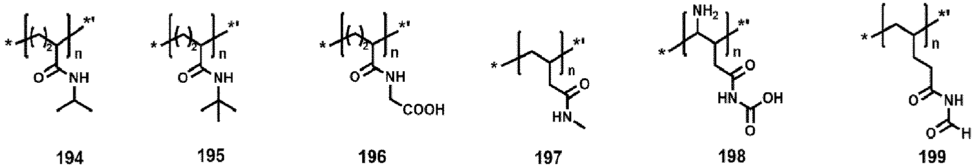

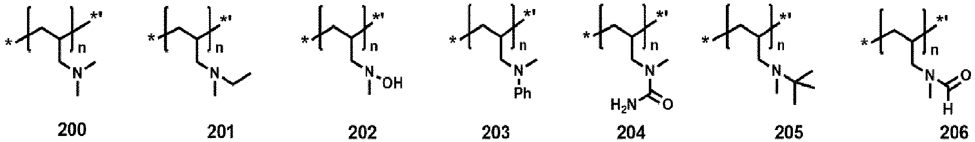

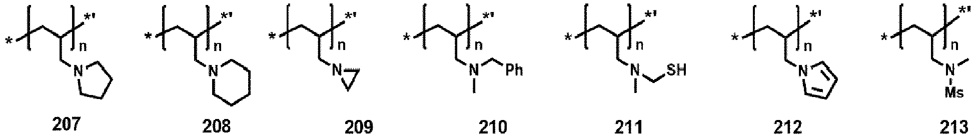

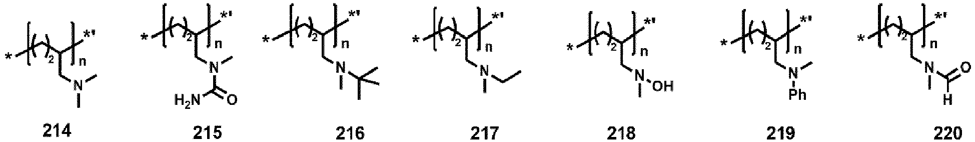

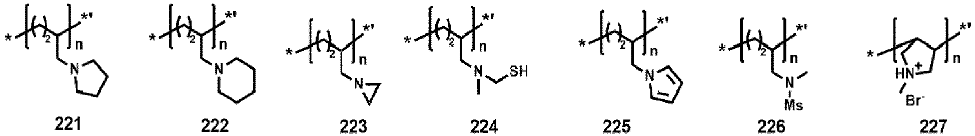

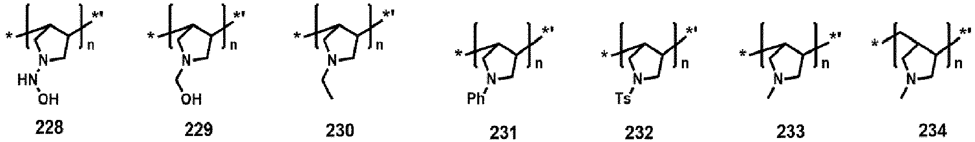

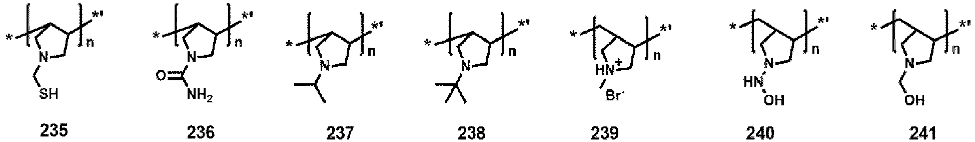

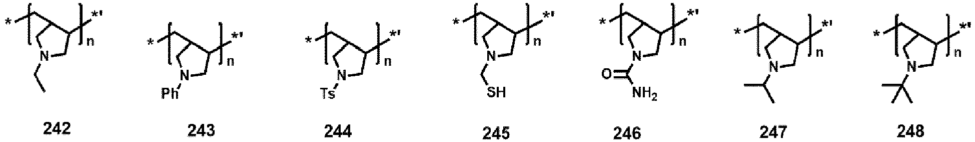

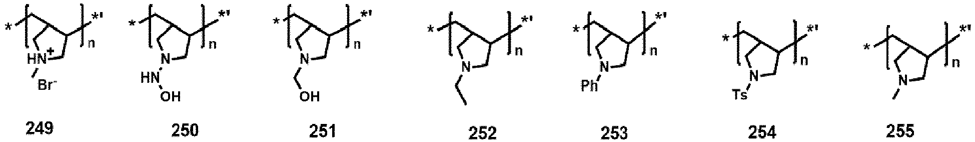

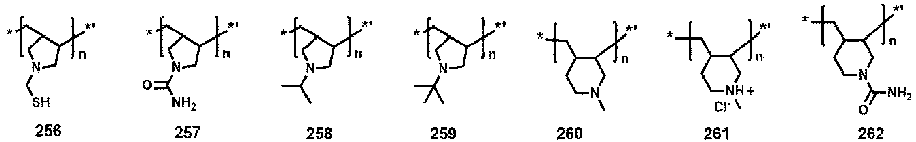

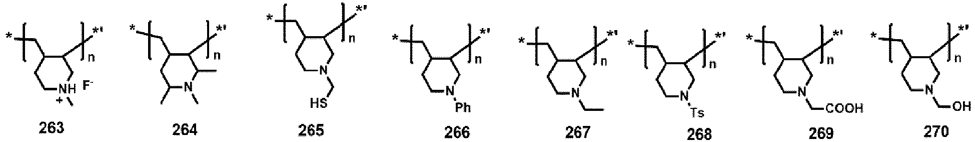

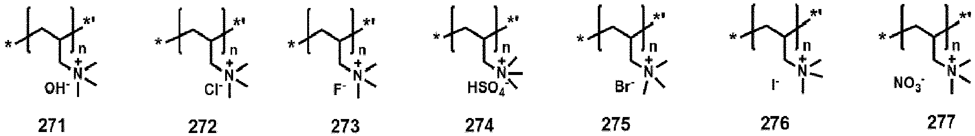

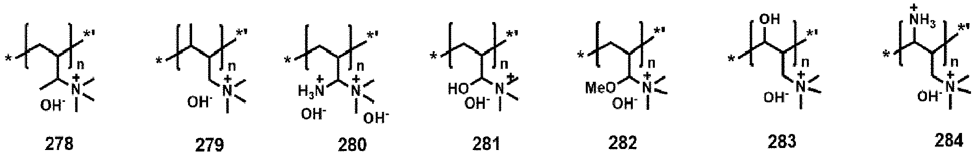

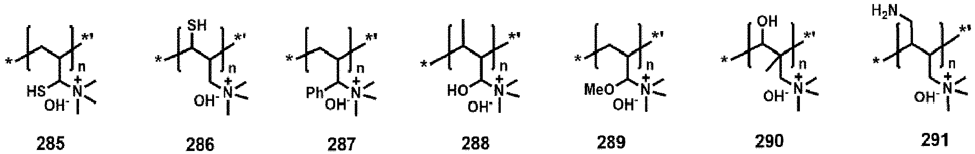

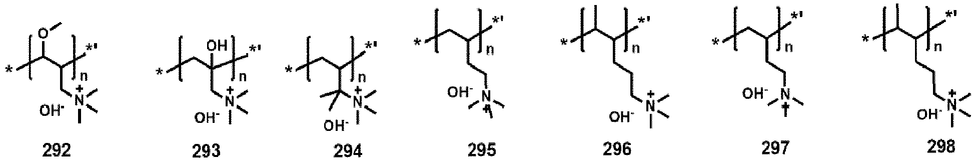

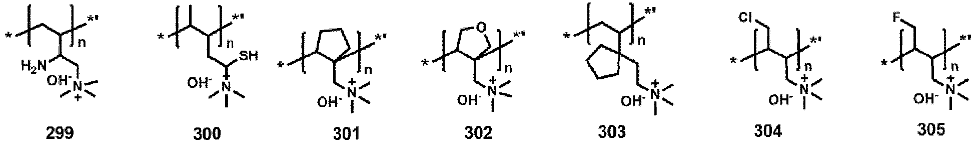

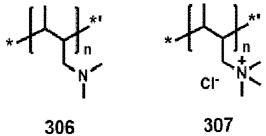

In Polymers 1 to 307,
OMe indicates a methoxy group,
Ph indicates a phenyl group,
PEG indicates a polyethylene glycol group (*-(O-CH₂-CH₂)ₙ₁-OH)(where n1 is an integer from 1 to 20),
Ts indicates a toluenesulfonyl group (*-S(=O)₂-(C₆H₄)-CH₃),
Ms indicates a methylsulfonyl group (*-S(=O)₂-CH₃),
n may be an integer from 2 to 10,000, and
* and *' each indicate a binding site to a neighboring atom.

Polymers 1 to 307 may have weight average molecular weights within the ranges described herein.

The selective etching inhibitor may further include an amine-containing compound different from the polymer having the nitrogen-containing repeating unit. By further including the amine-containing compound, the etching speed and etching selectivity for the titanium-containing layer may be effectively controlled.

In an embodiment, the amine-containing compound may include alkylamine, alkanolamine, or any combination thereof.

In one or more embodiments, the amine-containing compound may include monoalkylamine (e.g., monobutylamine), monoalkanolamine (e.g., ethanolamine), or any combination thereof.

In one or more embodiments, the amine-containing compound may include a compound represented by Formula 5:

Formula 5 N(Q₅₁)(Q₅₂)(Q₅₃)

In Formula 5, Q₅₁ to Q₅₃ may each independently be:
hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂; or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof, and
at least one of Q₅₁ to Q₅₃ may not be hydrogen.

For example, Q₅₁ to Q₅₃ may each independently be:
hydrogen; or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof, and
at least one of Q₅₁ to Q₅₃ may not be hydrogen.

For example, in Formula 5, Q₅₁ and Q₅₂ may each be hydrogen, and Q₅₃ may be: a C₁-C₂₀ alkyl group; or a C₁-C₂₀ alkyl group substituted with *-F, *-OH, or any combination thereof.

When the selective etching inhibitor further includes the amine-containing compound, a weight ratio of the polymer having the nitrogen-containing repeating unit to the amine-containing compound may be in a range of about 100:1 to about 1:10.

An amount (weight) of the selective etching inhibitor may be for example, based on a solid content of the selective etching inhibitor, in a range of 0.001wt% to 20 wt%, 0.001 wt% to 15 wt%, 0.001 wt% to 10 wt%, 0.001 wt% to 7 wt%, 0.001 wt% to 5 wt%, 0.001 wt% to 4 wt%, 0.001 wt% to 3 wt%, 0.001 wt% to 2 wt%, 0.001 wt% to 1 wt%, 0.001 wt% to 0.5 wt%, 0.001 wt% to 0.1 wt%, 0.005 wt% to 20 wt%, 0.005 wt% to 15 wt%, 0.005 wt% to 10 wt%, 0.005 wt% to 7 wt%, 0.005 wt% to 5 wt%, 0.005 wt% to 4 wt%, 0.005 wt% to 3 wt%, 0.005 wt% to 2 wt%, 0.005 wt% to 1 wt%, 0.005 wt% to 0.5 wt%, 0.005 wt% to 0.1 wt%, 0.01 wt% to 20 wt%, 0.01 wt% to 15 wt%, 0.01 wt% to 10 wt%, 0.01 wt% to 7 wt%, 0.01 wt% to 5 wt%, 0.01 wt% to 4 wt%, 0.01 wt% to 3 wt%, 0.01 wt% to 2 wt%, 0.01 wt% to 1 wt%, 0.01 wt% to 0.5 wt%, 0.01 wt% to 0.1 wt%, 0.05 wt% to 20 wt%, 0.05 wt% to 15 wt%, 0.05 wt% to 10 wt%, 0.05 wt% to 7 wt%, 0.05 wt% to 5 wt%, 0.05 wt% to 4 wt%, 0.05 wt% to 3 wt%, 0.05 wt% to 2 wt%, 0.0 5wt% to 1 wt%, 0.05 wt% to 0.5 wt%, or 0.05 wt% to 0.1 wt%, per 100 wt% of the etching composition.

In an embodiment, the amount of the oxidant may be in a range of about 0.5 wt% to about 20 wt% per 100 wt% of the etching composition, the amount of the inorganic acid may be in a range of about 30 wt% to about 80 wt% per 100 wt% of the etching composition, and the amount of the selective etching inhibitor is in a range of about 0.01 wt% to about 0.5 wt% per 100 wt% of the etching composition.

In an embodiment, the etching composition may further include, in addition to the oxidant, the inorganic acid, the selective etching inhibitor, and water, an organic acid. The organic acid may be, for example, acetic acid, tartaric acid, benzoic acid, or the like.

The aforementioned etching composition may have a pH in a range of about 1.0 to about 8.0, about 1.0 to about 7.0, about 1.0 to about 6.0, about 1.0 to about 5.0, about 1.0 to about 4.0, about 1.0 to about 3.0, about 2.0 to about 8.0, about 2.0 to about 7.0, about 2.0 to about 6.0, about 2.0 to about 5.0, about 2.0 to about 4.0, about 2.0 to about 3.0, about 3.0 to about 8.0, about 3.0 to about 7.0, about 3.0 to about 6.0, about 3.0 to about 5.0, about 3.0 to about 4.0, about 4.0 to about 8.0, about 4.0 to about 7.0, about 4.0 to about 6.0, about 4.0 to about 5.0, about 5.0 to about 8.0, about 5.0 to about 7.0, or about 5.0 to about 6.0. When the etching composition has a pH within the ranged above, the interaction between a selective etching inhibitor, which will be described later, and the metal atom in the titanium-containing layer may be more smoothly achieved.

In an embodiment, the etching composition may be used in an etching process and/or a CMP process for the titanium-containing layer. The titanium-containing layer is the same as defined herein.

In an embodiment, the etching composition may be used as a scavenger of an etching by-product, a scavenger of a post-etch process by-product, a scavenger of an ashing process by-product, a cleaning composition, a photoresist (PR) scavenger, an etching composition for packaging process, a cleaning agent for packaging process, a removing agent for adhesive substances of wafer, an etchant, a post-etch residue stripper, an ash residue cleaner, a PR residue stripper, a CMP cleaner, a post-CMP cleaner, or the like.

### Etching method of titanium-containing layer and manufacturing method of semiconductor device

By using the aforementioned etching composition, the titanium-containing layer may be effectively etched.

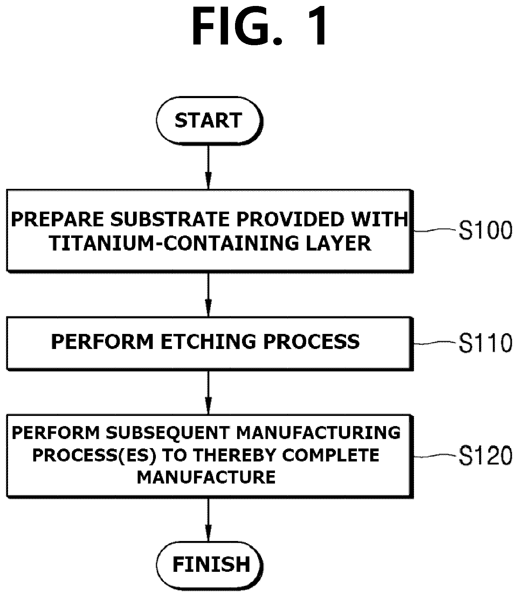

Referring to FIG. 1, an embodiment of an etching method of the titanium-containing layer may include: preparing a substrate provided with a titanium-containing layer (S100); and performing an etching process (S110) using the etching composition on the titanium-containing layer to remove at least a portion of the titanium-containing layer.

The titanium-containing layer may be the same as described herein.

By including the selective etching inhibitor, the etching composition may have excellent etching selectivity for the titanium-containing layer, and the productivity and efficiency of the etching process may be improved. Therefore, by using the etching process for the titanium-containing layer with the aforementioned etching composition, a semiconductor device having excellent performance may be prepared.

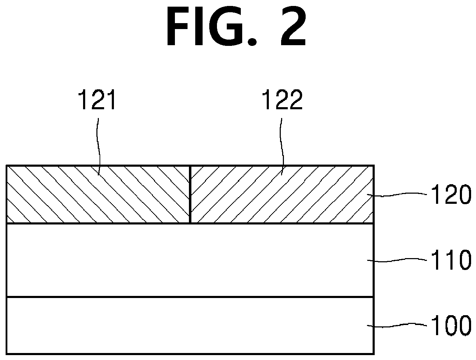

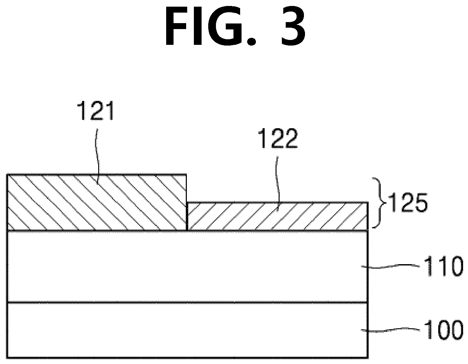

FIGS. 2 and 3 are each a diagram briefly explaining an embodiment of the method of etching the titanium-containing layer.

Referring to FIG. 2, a substrate 100 provided with a titanium-containing layer 120 may be provided. An interlayer 110 may be arranged between the substrate 100 and the titanium-containing layer 120. Although not shown in FIG. 2, circuitry elements (e.g., a transistor gate, metal lines, etc.) impurity regions, semiconductor layers, or the like may be disposed inside the substrate 100, on the substrate 100, and/or between the substrate 100 and the interlayer 110. In an embodiment, the titanium-containing layer 120 may be arranged directly on the substrate 100, and the interlayer 110 may be omitted.

The titanium-containing layer 120 may include a first region 121 and a second region 122. A second etching rate of the etching composition for etching the second region 122 may be greater than a first etching rate of the etching composition for etching the first region 121.

Referring to FIG. 3, when the etching composition is used for etching the titanium-containing layer 120, i) only at least a portion of the second region 122 may be etched, or ii) at least a portion of the second region 122 and at least a portion of the first region 121 may be etched, thereby forming a pattern of the metal-containing layer 125. The etching process may be performed by contacting at least a portion of the first region 121 with at least a portion of the second region 122 with the etching composition.

The etching composition may be used to etch i) only at least a portion of the second region 122, or ii) each of at least a portion of the second region 122 and at least a portion of the first region 121. Referring to FIG. 3, the pattern of the titanium-containing layer 125 formed after etching includes at least a portion of the second region 122, but if necessary, the etching process may be performed to completely remove the second region 122 from the pattern of the titanium-containing layer 125. Likewise, various modifications may be possible.

The first region 121 and the second region 122 may be the same as described herein.

In one or more embodiments, a) the first region 121, b) the second region 122, or c) the first region 121 and the second region 122, may include titanium (Ti).

In one or more embodiments, a) the first region 121, b) the second region 122, or c) the first region 121 and the second region 122, may include i) titanium nitride, ii) titanium nitride further including In, Al, La, Sc, Ga, Zn, Hf, or any combination thereof, or iii) a combination thereof.

In one or more embodiments, the first region 121 or the second region 122 may include a titanium nitride.

In one or more embodiments, a) the first region 121, b) the second region 122, or c) the first region 121 and the second region 122, may include In, Al, W, Co, La, Sc, Ga, Mo, Ru, Zn, Hf, or any combination thereof. In one or more embodiments, the first region 121 may include W, and the second region 122 may include titanium nitride (TiN).

In one or more embodiments, the first region 121 may include titanium nitride (TiN), and the second region 122 may include Mo.

In one or more embodiments, an etching rate ratio of the second region 122 to the first region 121 of the etching composition may be in a range of about 1.1 to about 30, about 1.1 to about 20, about 1.1 to about 15, about 1.1 to about 11, about 3 to about 30, about 3 to about 20, about 3 to about 15, or about 3 to about 11. The etching rate ratio of the second region 122 to the first region 121 of the etching composition may be obtained by dividing a second etching rate of the etching composition for etching the second region 122 by a first etching rate of the etching composition for etching the first region 121. When the etching rate ratio of the second region 122 to the first region 121 of the etching composition is within the ranges above, the efficiency and productivity of the etching process may be improved.

In one or more embodiments, the first region 121 may include W film, the second region 122 may include a titanium nitride film (TiN film), and an etching rate ratio of the second region 122 to the first region 121 of the etching composition (hereinafter referred to as "R(TiN / W)") may be in a range of about 1.1 to about 30, about 1.1 to about 20, about 1.1 to about 15, about 1.1 to about 11, about 3 to about 30, about 3 to about 20, about 3 to about 15, or about 3 to about 11. The R(TiN / W) may be obtained by dividing an etching rate of the etching composition for etching the second region 122 including a titanium nitride film (TiN film) by an etching rate of the etching composition for etching the first region 121 including a W film.

Referring to FIG. 1, a method of manufacturing a semiconductor device according to an embodiment may include: preparing a substrate provided with a titanium-containing layer (S100); performing an etching process (S110) using the etching composition on the titanium-containing layer to remove at least a portion of the titanium-containing layer; and manufacturing a semiconductor device by performing a subsequent process S120 on a structure including the substrate provided with the titanium-containing layer.

### Examples 1 to 10 and Comparative Example 1

Each of etching compositions of Examples 1 to 10 and Comparative Example 1 was prepared by mixing materials shown in Table 1 in an amount shown in Table 1. In Table 1, the oxidant is hydrogen peroxide, the inorganic acid is phosphoric acid, the weight average molecular weight of Polymers P1 to P5 was 1,600 g/mol, and the balance of each of the etching compositions is water (deionized water).

### Evaluation Example 1

After adding the etching composition of Example 1 to two beakers and heating until the temperature raised to 70 °C, a plasma-etched titanium nitride film (TiN film) and a tungsten film (W film) were immersed in each beaker for 5 minutes. Then, thicknesses of the TiN film and the W film were measured by using an ellipsometer (M-2000, J.A. Woolam), so as to evaluate the etching speed (Å/min) of the etching composition of Example 1 with respect to the TiN film and the W film. Subsequently, R(TiN / W) of the etching composition of Example 1 was evaluated by dividing the etching speed with respect to the TiN film by the etching speed with respect to the W film, and the results are summarized in Table 1.

The same tests were repeated by using the etching compositions of Examples 2 to 10 and Comparative Example 1, and the results are summarized in Table 1.

**Table 1**

| | Oxidant | Inorganic acid | Selective etching inhibitor | | | | R(TiN / W) |
|---|---|---|---|---|---|---|---|
| | Amount (wt%) | Amount (wt%) | Material 1 (polymer) | Solid content of Material 1 (wt%) | Material 2 | Amount of Material 2 (wt%) | |
| Example 1 | 4 | 70 | P1 | 0.5 | - | - | 10 |
| Example 2 | 4 | 70 | P1 | 0.25 | A | 0.25 | 11 |
| Example 3 | 4 | 70 | P1 | 0.01 | | | 10 |
| Example 4 | 4 | 70 | P1 | 0.015 | | | 8 |
| Example 5 | 4 | 70 | P1 | 0.0075 | | | 9 |
| Example 6 | 4 | 70 | P1 | 0.0015 | | | 10 |
| Example 7 | 4 | 70 | P2 | 0.01 | | | 9 |
| Example 8 | 4 | 70 | P3 | 0.01 | | | 6 |
| Example 9 | 4 | 70 | P4 | 0.01 | | | 4 |
| Example 10 | 4 | 70 | P5 | 0.01 | | | 3 |
| Comparative Example 1 | 4 | 70 | - | - | - | - | <1 |

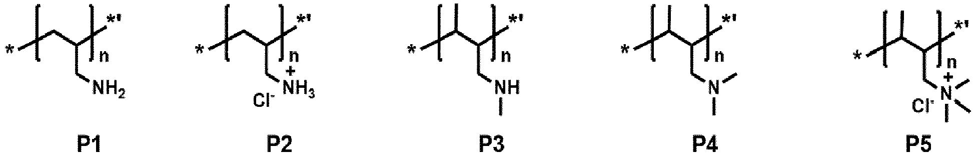

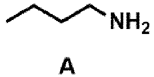

Referring to Table 1, it was confirmed that the etching compositions of Examples 1 to 10 were able to realize high etching selectivity of the TiN film to the W film compared to the etching composition of Comparative Example 1. Accordingly, the etching composition disclosed herein may be usefully utilized as an etching composition for the titanium-containing layer.

According to the one or more embodiments, an etching composition for a titanium-containing layer may have an excellent etching speed with respect to a titanium-containing layer and an excellent etching selectivity for adjacent layers and may be able to improve productivity and efficiency of an etching process, and thus use of the etching composition may lead to performance of an effective etching process and/or chemical mechanical polishing process on a target etching film, titanium-containing layer. Accordingly, a semiconductor device manufactured by using the etching process for the titanium-containing layer with the etching composition for the titanium-containing layer may have excellent performance.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An etching composition for a titanium-containing layer, comprising
an oxidant, an inorganic acid, and a selective etching inhibitor,
wherein the inorganic acid comprises phosphorus-based inorganic acid, chlorine-based inorganic acid, fluorine-based inorganic acid, or any combination thereof, and
the selective etching inhibitor comprises a polymer having a nitrogen-containing repeating unit.

2. The composition of claim 1, wherein the oxidant is hydrogen peroxide; and/or
wherein the inorganic acid comprises phosphoric acid; and/or
wherein the polymer having the nitrogen-containing repeating unit is a homopolymer.

3. The composition of claims 1 or 2, wherein the nitrogen-containing repeating unit comprises at least one of a repeating unit represented by Formula 1-1, a repeating unit represented by Formula 1-2, a repeating unit represented by Formula 1-3, and a repeating unit represented by Formula 1-4: 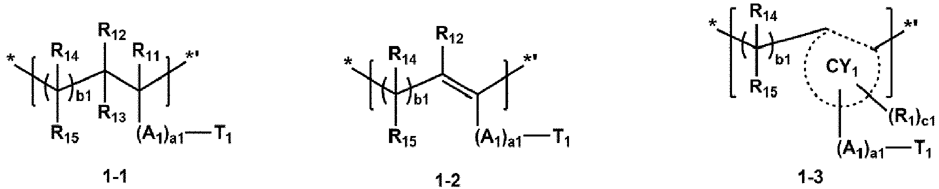 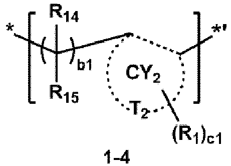
wherein A₁ in Formulae 1-1 to 1-3 is *-C(R₁₆)(R₁₇)-*', *-N(R₁₆)-*', *-C(=O)-*', *-O-*', or *-S-*',
a1 in Formulae 1-1 to 1-3 is an integer from 0 to 20, and when a1 is 2 or more, two or more of A₁ are identical to or different from each other,
b1 in Formulae 1-1 to 1-4 is an integer from 0 to 10, and when b1 is 2 or more, at least two of *-C(R₁₄)(R₁₅)-*' are identical to or different from each other,
T₁ in Formulae 1-1 to 1-3 is *-N(Z₁₁)(Z₁₂), *-[N(Z₁₁)(Z₁₂)(Z₁₃)⁺[Z₁₄]⁻, a group represented by Formula AN, or a group represented by Formula BN, 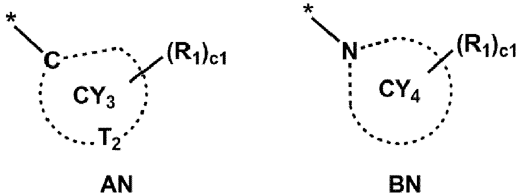
ring CY₁ to ring CY₄ in Formulae 1-3, 1-4, AN, and BN are each independently a C₂-C₁₀ cyclic group,
c1 in Formulae 1-3, 1-4, AN, and BN is an integer from 0 to 10, and when c1 is 2 or more, two or more of R₁ are identical to or different from each other,
T₂ in Formulae 1-4 and AN is *-N(Z₁₁)-*' or *-[N(Z₁₁)(Z₁₂)]⁺[Z₁₄]⁻-*',
R₁, R₁₁ to R₁₇, and Z₁₁ to Z₁₃ are each independently:
hydrogen, deuterium, *-F, *-Cl, *-Br, *-I, *-OH, *-SH, *-C(=O)-Q₁, *-NH-C(=O)-Q₁, *-C(=O)-O-O₁, *-SO₂-Q₁, *-P(=O)-(Q₁)(Q₂), *-N(Q₁)(Q₂), *-[N(Q₁)(Q₂)(Q₃)]⁺[Q₄]⁻, or *-(O-CH₂CH₂)ₙ₁-OH; or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-Q₁₁ , *-NH-C(=O)-Q₁₁, *-C(=O)-O-Q₁₁, *-SO₂-Q₁₁, *-P(=O)-(Q₁₁)(Q₁₂), *-N(Q₁₁)(Q₁₂), *-[N(Q₁₁)(Q₁₂)(Q₁₃)]⁺[Q₁₄]⁻, *-(O-CH₂CH₂)ₙ₂-OH, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof,
n1 and n2 are each independently an integer from 1 to 20,
two or more of R₁, R₁₁, R₁₂, R₁₃, R₁₄, R₁₅, R₁₆, R₁₇, Z₁₁, Z₁₂, and Z₁₃ are optionally linked together to form a C₂-C₁₀ cyclic group,
Q₁ to Q₃ and Q₁₁ to Q₁₃ are each independently:
hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂; or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof,
[Z₁₄]⁻, [Q₄]⁻, and [Q₁₄]⁻ are each an anion, and
* and *' each indicate a binding site to a neighboring atom.

4. The composition of claim 3, wherein CY₁ in Formula 1-3 is a cyclopropane group, a cyclobutane group, a cyclopentane group, a cyclohexane group, a cycloheptane group, a cyclooctane group, an oxirane group, an oxetane group, a tetrahydrofuran group, or a tetrahydropyran group; and/or
wherein ring CY₂ in Formula 1-4 is a saturated cyclic group having 4, 5, 6, or 7 carbon atoms.

5. The composition of claims 3 or 4, wherein, in Formula AN,
i) T₂ is *-N(Z₁₁)-*', and ring CY₃ is a pyrrole group, an imidazole group, a pyrazole group, an aziridine group, an azetidine group, a pyrrolidine group, or a piperidine group, or
ii) T₂ is *-[N(Z₁₁)(Z₁₂)⁺[Z₁₄]⁻-*', and ring CY₃ is a saturated cyclic group having 4, 5, 6, or 7 carbon atoms.

6. The composition of any of claims 3-5, wherein ring CY₄ in Formula BN is a pyrrole group, an imidazole group, a pyrazole group, an aziridine group, an azetidine group, a pyrrolidine group, or a piperidine group.

7. The composition of any of claims 3-6, wherein
the selective etching inhibitor comprises: a first polymer having a first nitrogen-containing repeating unit; and a second polymer having a second nitrogen-containing repeating unit,
the first nitrogen-containing repeating unit and the second nitrogen-containing repeating unit each independently comprise at least one of the repeating unit represented by Formula 1-1, the repeating unit represented by Formula 1-2, the repeating unit represented by Formula 1-3, and the repeating unit represented by Formula 1-4, and
the first nitrogen-containing repeating unit and the second nitrogen-containing repeating unit are different from each other.

8. The composition of any of claims 1-7, wherein
the selective etching inhibitor further comprises an amine-containing compound, and
the amine-containing compound is different from the polymer having the nitrogen-containing repeating unit;
preferably wherein the amine-containing compound comprises alkylamine, alkanolamine, or any combination thereof.

9. The composition of any of claims 1-8, wherein an amount of the selective etching inhibitor is in a range of 0.001 wt% to 20 wt% per 100 wt% of the etching composition.

10. The composition of any of claims 1-9, wherein
an amount of the oxidant is in a range of 0.5 wt% to 20 wt% per 100 wt% of the etching composition,
an amount of the inorganic acid is in a range of 30 wt% to 80 wt% per 100 wt% of the etching composition, and
an amount of the selective etching inhibitor is in a range of 0.01 wt% to 0.5 wt% per 100 wt% of the etching composition.

11. A method of etching a titanium-containing layer, the method comprising:
preparing a substrate provided with a titanium-containing layer; and
removing at least a portion of the titanium-containing layer by performing an etching process on the titanium-containing layer using the etching composition of any of claims 1-10.

12. The method of claim 11, wherein the titanium-containing layer further comprises indium (In), aluminum (Al), tungsten (W), cobalt (Co), lanthanum (La), scandium (Sc), gallium (Ga), molybdenum (Mo), ruthenium (Ru), zinc (Zn), hafnium (Hf), or any combination thereof.

13. The method of claims 11 or 12, wherein
the titanium-containing layer has a first region and a second region,
a second etching rate of the etching composition for etching the second region is greater than a first etching rate of the etching composition for etching the first region, and
the etching process is performed by contacting at least a portion of the first region and at least a portion of the second region with the etching composition,
preferably wherein the first region or the second region comprises titanium nitride (TiN).

14. The method of claim 13,
i) the first region comprises tungsten, and the second region comprises titanium nitride (TiN), or
ii) the first region comprises titanium nitride (TiN), and the second region comprises molybdenum (Mo).

15. A method of manufacturing a semiconductor device, the method comprising:
carrying out the method of any of claims 11-14; and
performing a subsequent manufacturing process on a structure having the substrate including the titanium-containing layer.
